# EUROPEAN PATENT APPLICATION

(11) **EP 4 693 773 A1**
(43) Date of publication of application: **11.02.2026**
(21) Application number: 24795562.8
(22) Date of filing: 23.02.2024
(51) Int. Cl.: H01S 5/50, H01S 3/067, G02F 1/39

(54) **OPTICAL AMPLIFIER AND RELATED DEVICE**

(30) Priority: 28.04.2023 CN 202310485918
(71) Applicant: Huawei Technologies Co., Ltd., Shenzhen, Guangdong 518129 (CN)
(72) Inventor: WANG, Wei, Shenzhen, Guangdong 518129 (CN); CHEN, Jie, Shenzhen, Guangdong 518129 (CN); LOU, Yang, Shenzhen, Guangdong 518129 (CN)
(74) Representative: Isarpatent
(86) International application number: PCT/CN2024/078275
(87) International publication number: WO 2024/222174

(57) **Abstract**

An optical amplifier and a related device are provided to reduce a nonlinear penalty of a gain medium. The optical amplifier includes a first gain medium, a second gain medium, a first multiplexer/demultiplexer, and a second multiplexer/demultiplexer. The second multiplexer/demultiplexer is configured to output, to the first gain medium in a coupling manner, a first optical signal and first gain clamping light output by the first multiplexer/demultiplexer. The first optical signal is an input optical signal of the optical amplifier, or is an optical signal obtained by amplifying the input optical signal of the optical amplifier. The first gain medium is configured to: amplify the first optical signal, and perform gain clamping on the first optical signal based on the first gain clamping light, to obtain target light. The second gain medium is configured to amplify the target light or the target light amplified through a target gain medium. The first multiplexer/demultiplexer is configured to separate the first gain clamping light from the target light amplified through the second gain medium.

## Description

This application claims priority to Chinese Patent Application No. CN202310485918.9, filed with the China National Intellectual Property Administration on April 28, 2023 and entitled "OPTICAL AMPLIFIER AND RELATED DEVICE", which is incorporated herein by reference in its entirety.

### TECHNICAL FIELD

Embodiments of this application relate to the field of optical communication, and in particular, to an optical amplifier and a related device.

### BACKGROUND

In optical communication, an optical amplifier is configured to amplify power of an optical signal. In the optical amplifier, different types of gain media may be used to amplify the optical signal, for example, an erbium doped fiber amplifier (erbium doped fiber amplifier, EDFA), a semiconductor amplifier (semiconductor optical amplifier, SOA), and a quantum dot optical amplifier.

Generally, in an optical transmission system, introduction of a nonlinear penalty by a gain medium is common. Specifically, when output power of the gain medium exceeds a specific threshold, a gain saturation effect occurs, which causes a nonlinear penalty, for example, distortion, of the optical signal, degrading transmission quality of the system.

### SUMMARY

Embodiments of this application provide an optical amplifier and a related device, to reduce a nonlinear penalty of a gain medium.

According to a first aspect, an embodiment of this application provides an optical amplifier. The optical amplifier includes a first gain medium, a second gain medium, a first multiplexer/demultiplexer, and a second multiplexer/demultiplexer. The second multiplexer/demultiplexer is connected to the first gain medium. The second multiplexer/demultiplexer is configured to output, to the first gain medium in a coupling manner, a first optical signal and first gain clamping light output by the first multiplexer/demultiplexer. The first optical signal is an input optical signal of the optical amplifier. Alternatively, the first optical signal is an optical signal obtained by amplifying an input optical signal of the optical amplifier. The first gain medium is configured to amplify the first optical signal, to obtain target light. In a process of amplifying the first optical signal through the first gain medium, the first gain medium performs gain clamping on the first optical signal based on the first gain clamping light. In this embodiment of this application, the target light is light obtained by amplifying the first optical signal through the first gain medium. The second gain medium is configured to amplify the target light or the target light amplified through a target gain medium. The first multiplexer/demultiplexer is configured to separate the first gain clamping light from the target light amplified through the second gain medium.

In this embodiment of this application, the optical signal is light in a communication band, for example, the first optical signal or a second optical signal, and represents different optical signals in the communication band. The gain clamping light is light outside the communication band, for example, the first gain clamping light or second gain clamping light, and represents different optical signals outside the communication band.

In this embodiment of this application, the first gain clamping light is light that is outside the communication band and that is separated from light generated through multi-stage amplification of the first optical signal. In a process of amplifying the first optical signal, the first gain medium implements gain clamping on the first optical signal by using the first gain clamping light. In other words, the first gain medium uses the light that is outside the communication band and that should be discarded in a communication process for gain clamping. Performing gain clamping on the first optical signal can improve saturated output power of the first gain medium, and reduce a nonlinear penalty of the first gain medium, thereby improving performance of the entire optical amplifier. Further, the light that is outside the communication band and that should be discarded in the communication process is utilized, so that utilization of light of the entire optical amplifier can be improved, and a requirement for an external light source (that is, a light source of the first gain clamping light) is reduced.

In an optional implementation, the first gain medium is connected to the second gain medium. The first gain medium is further configured to output the target light to the second gain medium. The second gain medium is configured to: amplify the target light, and output the amplified target light to the first multiplexer/demultiplexer.

In an optional implementation, the optical amplifier further includes the target gain medium. The target gain medium includes a third gain medium. The first gain medium, the third gain medium, and the second gain medium are sequentially connected. The third gain medium is configured to: receive the target light, amplify a second optical signal based on first pump light, and output the amplified target light to the second gain medium. The first pump light is light outside a communication band in the target light, and the second optical signal is light in the communication band in the target light. The second gain medium is configured to: amplify the target light amplified through the third gain medium, and output the amplified target light to the first multiplexer/demultiplexer. The first multiplexer/demultiplexer is specifically configured to separate the first gain clamping light from the target light amplified through the third gain medium and the second gain medium.

In this embodiment of this application, the third gain medium amplifies the second optical signal by using the first pump light outside the communication band in the target light, further improving utilization of the light outside the communication band. This structure can reduce an optical power requirement of a pump light source of the third gain medium and reduce energy consumption. Alternatively, a pump light source of the third gain medium can be omitted, simplifying a device structure.

In an optional implementation, the optical amplifier further includes a pump light source. The pump light source is connected to the third gain medium. The pump light source is configured to provide second pump light. The third gain medium is configured to: perform multiplexing on the second pump light and the first pump light to obtain target pump light, and amplify the second optical signal based on the target pump light.

In this embodiment of this application, the third gain medium can match optimal pump light power of the third gain medium by using the second pump light, to supplement a difference between optical power of the first pump light and the optimal pump light power (of the third gain medium), thereby improving a pump effect. Alternatively, the third gain medium can adjust total power of pump light input to the third gain medium by using the pump light source, so as to match different gain requirements, implementing gain adjustment of the entire optical amplifier.

In an optional implementation, the optical amplifier further includes the target gain medium. The target gain medium includes a fourth gain medium. The first gain medium, the fourth gain medium, and the second gain medium are sequentially connected. The fourth gain medium is configured to: receive the target light, amplify a second optical signal, perform gain clamping on the second optical signal based on second gain clamping light, and output the amplified target light to the second gain medium. The second optical signal is light in a communication band in the target light, and the second gain clamping light is light outside the communication band in the target light. The second gain medium is configured to: amplify the target light amplified through the fourth gain medium, and output the amplified target light to the first multiplexer/demultiplexer. The first multiplexer/demultiplexer is specifically configured to separate the first gain clamping light from the target light amplified through the fourth gain medium and the second gain medium.

In this embodiment of this application, the second gain clamping light is the light outside the communication band in the target light. In a process of amplifying the second optical signal, the fourth gain medium implements gain clamping on the second optical signal by using the second gain clamping light. In other words, the fourth gain medium uses the light that is outside the communication band and that should be discarded in the target light for gain clamping. Performing gain clamping on the second optical signal can improve saturated output power of the fourth gain medium, and reduce a nonlinear penalty of the fourth gain medium, thereby improving performance of the entire optical amplifier. Further, the light that is outside the communication band and that should be discarded in the communication process is utilized, so that utilization of light of the entire optical amplifier can be improved, and a requirement for an external light source (that is, a light source of the second gain clamping light) is reduced.

In an optional implementation, the optical amplifier further includes a third multiplexer/demultiplexer and the target gain medium. The target gain medium includes a fourth gain medium. The first gain medium, the third multiplexer/demultiplexer, the fourth gain medium, and the second gain medium are sequentially connected. The third multiplexer/demultiplexer is further connected to the first multiplexer/demultiplexer. The first multiplexer/demultiplexer is further configured to: separate third gain clamping light from the target light amplified through the second gain medium, and output the third gain clamping light to the third multiplexer/demultiplexer. The third multiplexer/demultiplexer is configured to: receive the target light, and output the third gain clamping light and the target light to the fourth gain medium in a coupling manner. The fourth gain medium is configured to: amplify the target light obtained by the third multiplexer/demultiplexer through coupling, perform gain clamping on the target light based on the third gain clamping light, and output the amplified target light to the second gain medium. The second gain medium is configured to: amplify the target light amplified through the fourth gain medium, and output the amplified target light to the first multiplexer/demultiplexer. The first multiplexer/demultiplexer is specifically configured to separate the first gain clamping light from the target light amplified through the fourth gain medium and the second gain medium.

In this embodiment of this application, the first multiplexer/demultiplexer separates the first gain clamping light and the third gain clamping light from the target light amplified through the second gain medium. The two channels of gain clamping light are respectively used to implement gain clamping on the optical signal on the first gain medium and the fourth gain medium. This can reduce nonlinear penalties of the first gain medium and the fourth gain medium, and can improve utilization of the light outside the communication band.

In an optional implementation, the optical amplifier further includes the target gain medium. The target gain medium includes a third gain medium and a fourth gain medium. The first gain medium, the fourth gain medium, the third gain medium, and the second gain medium are sequentially connected. The fourth gain medium is configured to: receive the target light, amplify a second optical signal, perform gain clamping on the second optical signal based on second gain clamping light, and output the amplified target light to the third gain medium. The second optical signal is light in a communication band in the target light, and the second gain clamping light is light outside the communication band in the target light. The third gain medium is configured to: receive the target light amplified through the fourth gain medium, amplify a third optical signal based on third pump light, and output the amplified target light to the second gain medium. The third pump light is light outside the communication band in the target light amplified through the fourth gain medium, and the third optical signal is light in the communication band in the target light amplified through the fourth gain medium. The second gain medium is configured to: amplify the target light amplified through the fourth gain medium and the third gain medium, and output the amplified target light to the first multiplexer/demultiplexer. The first multiplexer/demultiplexer is specifically configured to separate the first gain clamping light from the target light amplified through the fourth gain medium, the third gain medium, and the second gain medium.

In this embodiment of this application, the fourth gain medium uses the light (the second gain clamping light) outside the communication band in the target light for gain clamping, so that a nonlinear penalty of the fourth gain medium can be reduced. In the target light amplified through the third gain medium by using the fourth gain medium, the third pump light outside the communication band amplifies the third optical signal, further improving utilization of the light outside the communication band.

In an optional implementation, the optical amplifier further includes a pump light source. The pump light source is connected to the third gain medium. The pump light source is configured to provide second pump light. The third gain medium is configured to: perform multiplexing on the second pump light and the third pump light to obtain target pump light, and amplify the third optical signal based on the target pump light.

In this embodiment of this application, the third gain medium can match optimal pump light power of the third gain medium by using the second pump light, to supplement a difference between optical power of the third pump light and the optimal pump light power (of the third gain medium), thereby improving a pump effect. Alternatively, the third gain medium can adjust total power of pump light input to the third gain medium by using the pump light source, so as to match different gain requirements, implementing gain adjustment of the entire optical amplifier.

**In** an optional implementation, the optical amplifier further includes a third multiplexer/demultiplexer and the target gain medium. The target gain medium includes a third gain medium and a fourth gain medium. The first gain medium, the third multiplexer/demultiplexer, the fourth gain medium, the third gain medium, and the second gain medium are sequentially connected. The third multiplexer/demultiplexer is further connected to the first multiplexer/demultiplexer. The first multiplexer/demultiplexer is further configured to: separate third gain clamping light from the target light amplified through the second gain medium, and output the third gain clamping light to the third multiplexer/demultiplexer. The third multiplexer/demultiplexer is configured to: receive the target light, and output the third gain clamping light and the target light to the fourth gain medium in a coupling manner. The fourth gain medium is configured to: amplify the target light obtained by the third multiplexer/demultiplexer through coupling, perform gain clamping on the target light based on the third gain clamping light, and output the amplified target light to the third gain medium. The third gain medium is configured to: receive the target light amplified through the fourth gain medium, amplify a fourth optical signal based on fourth pump light, and output the amplified target light to the second gain medium. The fourth pump light is light outside a communication band in the target light amplified through the fourth gain medium, and the fourth optical signal is light in the communication band in the target light amplified through the fourth gain medium. The second gain medium is configured to: amplify the target light amplified through the fourth gain medium and the third gain medium, and output the amplified target light to the first multiplexer/demultiplexer. The first multiplexer/demultiplexer is specifically configured to separate the first gain clamping light from the target light amplified through the fourth gain medium, the third gain medium, and the second gain medium.

**In** this embodiment of this application, the first multiplexer/demultiplexer separates the first gain clamping light and the third gain clamping light from the target light amplified through the second gain medium. The two channels of gain clamping light are respectively used to implement gain clamping on the optical signal on the first gain medium and the fourth gain medium. This can reduce nonlinear penalties of the first gain medium and the fourth gain medium. In the target light amplified through the third gain medium by using the fourth gain medium, the fourth pump light outside the communication band amplifies the fourth optical signal, further improving utilization of the light outside the communication band.

In an optional implementation, the optical amplifier further includes a pump light source. The pump light source is connected to the third gain medium. The pump light source is configured to provide second pump light. The third gain medium is configured to: perform multiplexing on the second pump light and the fourth pump light to obtain target pump light, and amplify the fourth optical signal based on the target pump light.

In this embodiment of this application, the third gain medium can match optimal pump light power of the third gain medium by using the second pump light, to supplement a difference between optical power of the third pump light and the optimal pump light power (of the third gain medium), thereby improving a pump effect. Alternatively, the third gain medium can adjust total power of pump light input to the third gain medium by using the pump light source, so as to match different gain requirements, implementing gain adjustment of the entire optical amplifier.

**In** an optional implementation, the optical amplifier further includes a fourth multiplexer/demultiplexer and a third gain medium. The first gain medium, the fourth multiplexer/demultiplexer, the second gain medium, and the third gain medium are sequentially connected. The fourth multiplexer/demultiplexer is further connected to the third gain medium. The fourth multiplexer/demultiplexer is configured to: receive the target light, output first pump light to the third gain medium, and output a second optical signal to the second gain medium. The first pump light is light outside a communication band in the target light, and the second optical signal is light in the communication band in the target light. The second gain medium is configured to: amplify the second optical signal, and output the amplified target light to the third gain medium. The third gain medium is configured to amplify, based on the first pump light, the target light amplified through the second gain medium.

**In** this embodiment of this application, the third gain medium amplifies the second optical signal by using the first pump light outside the communication band in the target light, further improving utilization of the light outside the communication band. This structure can reduce an optical power requirement of a pump light source of the third gain medium and reduce energy consumption. Alternatively, a pump light source of the third gain medium can be omitted, simplifying a device structure.

**In** an optional implementation, the optical amplifier further includes a narrow band-pass filter. The narrow band-pass filter is included in a target loop. The target loop includes the second multiplexer/demultiplexer, the first gain medium, the second gain medium, and the first multiplexer/demultiplexer. The target loop is configured to transmit the first gain clamping light. The narrow band-pass filter is configured to control a bandwidth of the first gain clamping light, to generate laser light on the target loop based on the first gain clamping light.

In this embodiment of this application, the first gain clamping light is transmitted in the target loop. The bandwidth of the first gain clamping light is controlled by using the narrow band-pass filter, so that the laser light can be generated on the target loop based on the first gain clamping light. Because intensity of the laser light (the first gain clamping light) is high, the first gain clamping light outside the communication band and the optical signal in the communication band may preempt energy of the pump light. If a quantity of beams of the optical signal suddenly changes (for example, from 120 wavelengths to 10 wavelengths), the first gain clamping light may be used to preempt the energy of the pump light, to prevent the sudden change of energy of the optical signal on the gain medium, thereby preventing transient overshoot.

Optionally, the target loop may further include the third gain medium, the fourth gain medium, and the like. This is not limited in this application.

In an optional implementation, the optical amplifier further includes a fifth gain medium. The fifth gain medium is connected to the second multiplexer/demultiplexer. The first optical signal is the optical signal obtained by amplifying the input optical signal of the optical amplifier. The fifth gain medium is configured to: receive and amplify the input signal of the optical amplifier, to obtain the first optical signal, and output the first optical signal to the second multiplexer/demultiplexer.

In this embodiment of this application, the input optical signal of the optical amplifier is amplified through the fifth gain medium before entering the second multiplexer/demultiplexer, which can reduce an insertion loss of the optical signal due to the second multiplexer/demultiplexer.

In an optional implementation, a nonlinear penalty of the first gain medium is higher than a nonlinear penalty of the second gain medium.

In embodiments of this application, the first gain medium with a high nonlinear penalty but a large gain is used to increase a gain and reduce a noise factor (noise factor, NF). The second gain medium with a low nonlinear penalty is used to improve output power of the entire optical amplifier. The first gain clamping light may further implement gain clamping on the first optical signal on the first gain medium. In this way, the optical amplifier has advantages such as high gain, low NF, and low nonlinear penalty.

Optionally, the nonlinear penalty of the first gain medium may alternatively be less than the nonlinear penalty of the second gain medium, or the nonlinear penalty of the first gain medium is the same as the nonlinear penalty of the second gain medium. This is not limited in this application.

In an optional implementation, the first gain medium includes at least one of the following: a semiconductor amplifier SOA and a planar waveguide gain medium.

In an optional implementation, the second gain medium includes at least one of the following: a doped gain fiber and a planar waveguide gain medium.

In an optional implementation, the optical amplifier further includes a variable optical attenuator (variable optical attenuator, VOA). The VOA is located between the first multiplexer/demultiplexer and the second multiplexer/demultiplexer, and is configured to adjust power of the gain clamping light.

In this embodiment of this application, the VOA can adjust power of the first gain clamping light, to match an optimal power point of gain clamping on the first gain medium. In this way, NF performance of the optical amplifier is ensured as much as possible (a decrease of an optical signal-to-noise ratio at an output end of the optical amplifier is suppressed as much as possible) on the premise that the power of the first gain clamping light is as large as possible (a gain clamping effect is ensured).

In an optional implementation, the first gain clamping light is forward amplified spontaneous emission (amplified spontaneous emission, ASE) light or backward ASE light of the second gain medium.

According to a second aspect, an embodiment of this application provides an optical amplifier. The optical amplifier includes a first gain medium, a first multiplexer/demultiplexer, and a second multiplexer/demultiplexer. The second multiplexer/demultiplexer, the first gain medium, and the first multiplexer/demultiplexer are sequentially connected. The second multiplexer/demultiplexer is configured to output, to the first gain medium in a coupling manner, a first optical signal and first gain clamping light output by the first multiplexer/demultiplexer. The first optical signal is an input optical signal of the optical amplifier, or the first optical signal is an optical signal obtained by amplifying the input optical signal of the optical amplifier. The first gain medium is configured to: amplify the first optical signal, and perform gain clamping on the first optical signal based on the first gain clamping light, to obtain target light. The first multiplexer/demultiplexer is configured to separate the first gain clamping light from the target light.

In this embodiment of this application, the first gain clamping light is light that is separated from the target light (generated after the first optical signal is amplified through the first gain medium) and that is outside a communication band. In addition, in a process of amplifying the first optical signal, the first gain medium implements gain clamping on the first optical signal by using the first gain clamping light. In other words, the first gain medium uses the light that is outside the communication band and that should be discarded in a communication process for gain clamping. Performing gain clamping on the first optical signal can improve saturated output power of the first gain medium, and reduce a nonlinear penalty of the first gain medium, thereby improving performance of the entire optical amplifier. Further, the light that is outside the communication band and that should be discarded in the communication process is utilized, so that utilization of light of the entire optical amplifier can be improved, and a requirement for an external light source (that is, a light source of the first gain clamping light) is reduced.

In an optional implementation, the first optical signal is the input optical signal of the optical amplifier. The optical amplifier further includes an input port. The second multiplexer/demultiplexer is connected to the input port. The input port is configured to receive the input optical signal of the optical amplifier, and output the input optical signal to the second multiplexer/demultiplexer.

In an optional implementation, the first optical signal is the optical signal obtained by amplifying the input optical signal of the optical amplifier. The optical amplifier further includes a fifth gain medium. The fifth gain medium is connected to the second multiplexer/demultiplexer. The fifth gain medium is configured to: receive and amplify the input optical signal of the optical amplifier, to obtain the first optical signal, and output the first optical signal to the second multiplexer/demultiplexer.

In this embodiment of this application, the input optical signal of the optical amplifier is amplified through the fifth gain medium before entering the second multiplexer/demultiplexer, which can reduce an insertion loss of the optical signal due to the second multiplexer/demultiplexer.

In an optional implementation, the optical amplifier further includes a narrow band-pass filter. The narrow band-pass filter is included in a target loop. The target loop includes the second multiplexer/demultiplexer, the first gain medium, and the first multiplexer/demultiplexer. The target loop is configured to transmit the first gain clamping light. The narrow band-pass filter is configured to control a bandwidth of the first gain clamping light, to generate laser light on the target loop based on the first gain clamping light.

In this embodiment of this application, the first gain clamping light is transmitted in the target loop. The bandwidth of the first gain clamping light is controlled by using the narrow band-pass filter, so that the laser light can be generated on the target loop based on the first gain clamping light. Because intensity of the laser light (the first gain clamping light) is high, the first gain clamping light outside the communication band and the optical signal in the communication band may preempt energy of the pump light. If a quantity of beams of the optical signal suddenly changes, the first gain clamping light may be used to preempt the energy of the pump light, to prevent the sudden change of energy of the optical signal on the gain medium, thereby preventing transient overshoot.

According to a third aspect, an embodiment of this application provides an optical communication device. The optical communication device includes the optical amplifier according to the first aspect or the second aspect.

According to a fourth aspect, an embodiment of this application provides an optical communication system. The optical communication system includes the optical amplifier according to the first aspect or the second aspect.

### BRIEF DESCRIPTION OF DRAWINGS

FIG. 1 is a diagram of an optical communication system according to this application;
FIG. 2 is a diagram of a structure of an optical amplifier according to an embodiment of this application;
FIG. 3 is a diagram of a structure of an optical amplifier including a fifth multiplexer/demultiplexer according to an embodiment of this application;
FIG. 4 is a diagram of a structure of another optical amplifier including a fifth multiplexer/demultiplexer according to an embodiment of this application;
FIG. 5 is a diagram of a structure of an optical amplifier including a target loop according to an embodiment of this application;
FIG. 6 is a diagram of a structure of an optical amplifier including a third gain medium according to an embodiment of this application;
FIG. 7 is a diagram of a structure of an optical amplifier in which a pump light source is additionally disposed for a third gain medium according to an embodiment of this application;
FIG. 8 is a diagram of a structure of an optical amplifier in which a position of a first multiplexer/demultiplexer is changed according to an embodiment of this application;
FIG. 9 is a diagram of a structure of an optical amplifier in which a position of a third gain medium is changed according to an embodiment of this application;
FIG. 10 is a diagram of a structure of another optical amplifier including a target loop according to an embodiment of this application;
FIG. 11 is a diagram of a structure of an optical amplifier that includes a target loop and whose gain is adjustable according to an embodiment of this application;
FIG. 12 is a diagram of a structure of an optical amplifier including a fourth gain medium according to an embodiment of this application;
FIG. 13 is a diagram of a structure of another optical amplifier including a fourth gain medium according to an embodiment of this application;
FIG. 14 is a diagram of a structure of an optical amplifier including a third gain medium and a fourth gain medium according to an embodiment of this application;
FIG. 15 is a diagram of a structure of an optical amplifier including a fifth gain medium according to an embodiment of this application; and
FIG. 16 is a diagram of a structure of an optical amplifier for separating first gain clamping light from target light according to an embodiment of this application.

### DESCRIPTION OF EMBODIMENTS

The following describes embodiments of this application with reference to the accompanying drawings.

In the specification, claims, and accompanying drawings of this application, the terms "first", "second", and so on are intended to distinguish between similar objects but do not necessarily indicate a specific order or sequence. It should be understood that the terms used in such a way are interchangeable in appropriate circumstances, which is merely a discrimination manner that is used when objects having a same attribute are described in embodiments of this application. In addition, the terms "include", "have", and any other variants thereof are intended to cover non-exclusive inclusion, so that a process, method, system, product, or device that includes a series of units is not necessarily limited to those units, but may include other units not expressly listed or inherent to such a process, method, product, or device. In addition, "at least one" means one or more, and "a plurality of" means two or more. The term "and/or" describes an association relationship between associated objects and represents that three relationships may exist. For example, A and/or B may represent the following three cases: Only A exists, both A and B exist, and only B exists. A and B may be singular or plural. The character "/" generally indicates an "or" relationship between the associated objects. "At least one item (piece) of the following" or a similar expression thereof means any combination of these items, including a singular item (piece) or any combination of plural items (pieces). For example, at least one item (piece) of a, b, or c may represent a, b, c, a and b, a and c, b and c, or a, b, and c.

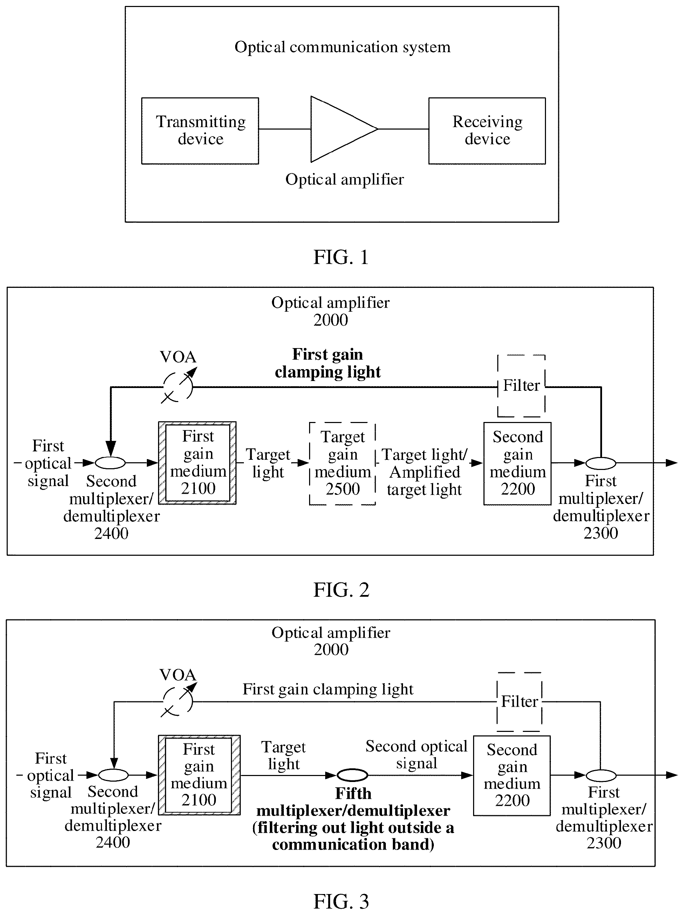

FIG. 1 is a diagram of a structure of an optical communication system. The optical communication system includes a transmitting device, a receiving device, and an optical fiber. The transmitting device is configured to perform electro-optical modulation, to include a signal in an optical signal, and input the optical signal into the optical fiber for transmission. The optical fiber is configured to transmit the optical signal. The receiving device is configured to receive and parse the optical signal.

As shown in FIG. 1, the optical communication system may further include an optical amplifier. The optical amplifier is located between the transmitting device and the receiving device. The optical amplifier is configured to relay and amplify the optical signal, to increase power of the optical signal at the receiving device. In this way, signal attenuation and distortion are reduced, and signal transmission reliability and transmission quality are improved.

Optionally, the optical amplifier can also exist in any optical communication device (for example, the transmitting device, the receiving device, or a relay node) in the optical communication system, and is configured to amplify an optical signal.

The optical amplifier includes a plurality of types of gain media, configured to amplify an optical signal. These gain media include but are not limited to an erbium doped fiber (erbium doped fiber, EDF), a semiconductor optical amplifier (semiconductor optical amplifier, SOA), and a quantum dot optical amplifier. This is not limited in this application.

When high-energy photons (optical signals) pass through the gain medium, the high-energy photons interact with atoms, ions, molecules, and other particles in the gain medium. As a result, an internal state of the gain medium changes, and optical properties of the gain medium are affected. If power of the optical signal is greater than or equal to saturated output power of the gain medium, the interaction will cause nonlinear behavior such as frequency mixing effect and phase modulation between optical waves of different frequencies. The foregoing effect or behavior causes nonlinear distortion in propagation and amplification of a light field, which affects stability and precision of signal transmission and amplification. This phenomenon is referred to as a nonlinear penalty of the gain medium.

In a process of amplifying an optical signal, due to the nonlinear penalty of the gain medium, problems such as distortion (deformation or twisting), phase noise, and inter-channel crosstalk may occur on the optical signal, which affects performance of the optical amplifier.

To resolve the foregoing problems, embodiments of this application provide an optical amplifier and a related device. In embodiments of this application, light that is output by a next-level gain medium and that is outside a communication band is input to a previous-level gain medium as gain clamping light, to reduce a nonlinear penalty of the previous-level gain medium, thereby improving performance of the entire optical amplifier.

As shown in FIG. 2, an optical amplifier 2000 provided in this embodiment of this application includes a first gain medium 2100, a second gain medium 2200, a first multiplexer/demultiplexer 2300, and a second multiplexer/demultiplexer 2400. The second multiplexer/demultiplexer 2400 is connected to the first gain medium 2100.

The second multiplexer/demultiplexer 2400 includes a plurality of branch ports and a common port. One branch port of the second multiplexer/demultiplexer 2400 is connected to the first multiplexer/demultiplexer 2300, and one branch port is configured to receive first light signal. The first optical signal is an input optical signal of the optical amplifier 2000. Alternatively, the first optical signal is an optical signal obtained by amplifying an input optical signal of the optical amplifier 2000. The common port of the second multiplexer/demultiplexer 2400 is connected to the first gain medium 2100. The second multiplexer/demultiplexer 2400 is configured to output, to the first gain medium 2100 in a coupling manner, the first optical signal and first gain clamping light output by the first multiplexer/demultiplexer 2300.

The first gain medium 2100 is configured to amplify the first optical signal, to obtain target light. In this embodiment of this application, the target light is light obtained by amplifying the first optical signal through the first gain medium 2100. In a process of amplifying the first optical signal through the first gain medium 2100, the first gain medium 2100 performs gain clamping on the first optical signal based on the first gain clamping light.

The second gain medium 2200 is configured to amplify the target light. Alternatively, if the optical amplifier 2000 further includes a target gain medium 2500 (as shown in a dashed line box in FIG. 2), the second gain medium 2200 is configured to amplify the target light amplified through the target gain medium 2500.

The first multiplexer/demultiplexer 2300 is configured to separate the first gain clamping light from the target light amplified through the second gain medium.

**In** this embodiment of this application, light is split into an optical signal (for example, the first optical signal or a second optical signal) in a communication band and light outside the communication band based on a band of the light. The communication band is a band that is defined in an optical communication system and that is used for communication, and the communication band specifically depends on a network configuration. For example, in the optical communication system, if an L band is set to transmit a signal, the L band is the communication band, and light outside the L band (for example, light in bands such as a C band and an O band) is the light outside the communication band.

The light outside the communication band includes gain clamping light (for example, the first gain clamping light and second gain clamping light), pump light (for example, first pump light and second pump light), and the like. This is not limited in this application.

**In** this embodiment of this application, the first gain clamping light is light that is outside the communication band and that is separated from light generated through multi-stage amplification of the first optical signal (through the first gain medium 2100, the second gain medium 2200, and the target gain medium that does not necessarily exist). In a process of amplifying the first optical signal, the first gain medium 2100 implements gain clamping on the first optical signal by using the first gain clamping light. In other words, the first gain medium 2100 uses the light that is outside the communication band and that should be discarded in a communication process for gain clamping. Performing gain clamping on the first optical signal can improve saturated output power of the first gain medium 2100, and reduce a nonlinear penalty of the first gain medium 2100, thereby improving performance of the entire optical amplifier 2000. Further, the light that is outside the communication band and that should be discarded in the communication process is utilized, so that utilization of light of the entire optical amplifier 2000 can be improved, and a requirement for an external light source (that is, a light source of the first gain clamping light) is reduced.

Optionally, in addition to the first multiplexer/demultiplexer 2300 and the second multiplexer/demultiplexer 2400, the optical amplifier 2000 may further include more multiplexers/demultiplexers. A type of the multiplexer/demultiplexer is not limited in embodiments of this application. The multiplexer/demultiplexer may be a wavelength division multiplexer (wavelength division multiplexing, WDM), a filter (filter), or the like. This is not limited in this application.

In embodiments of this application, types of the first gain medium 2100 and the second gain medium 2200 are not limited. Optionally, the first gain medium 2100 is an SOA, a planar waveguide gain medium (for example, a lithium niobate LiNbO3), or a doped fiber (for example, an erbium doped fiber EDF or a bismuth doped fiber (bismuth doped fiber, BDF)). This is not limited in this application. This is similar for the second gain medium 2200, and details are not described herein again.

In this structure, the gain clamping light may be forward amplified spontaneous emission (amplified spontaneous emission, ASE) light of the second gain medium 2200. Optionally, the gain clamping light may alternatively be backward ASE light of the second gain medium 2200. This is not limited in this application. If the gain clamping light is the backward ASE light of the second gain medium 2200, the first multiplexer/demultiplexer 2300 should be located on a left side of the second gain medium 2200 in FIG. 2.

Optionally, the nonlinear penalty of the first gain medium 2100 is higher than a nonlinear penalty of the second gain medium 2200. In embodiments of this application, the first gain medium 2100 with a high nonlinear penalty but a large gain is used to increase a gain and reduce a noise factor (noise factor, NF). The second gain medium 2200 with a low nonlinear penalty is used to improve output power of the entire optical amplifier 2000. The first gain clamping light can further implement gain clamping on the first optical signal on the first gain medium 2100. In this way, the optical amplifier has advantages such as high gain, low NF, and low nonlinear penalty.

For ease of differentiation, in embodiments of this application, a thick frame filled with slashes represents a gain medium with a high nonlinear penalty (for example, the first gain medium 2100 in FIG. 2), and an ordinary block represents a gain medium with a low nonlinear penalty (for example, the second gain medium 2200 in FIG. 2).

For example, in a structure shown in any embodiment (for example, FIG. 2) of this application, the first gain medium 2100 is an SOA or a quantum dot optical amplifier with a high nonlinear penalty, and the second gain medium 2200 is an EDF with a low nonlinear penalty.

Alternatively, the nonlinear penalty of the first gain medium 2100 may be less than the nonlinear penalty of the second gain medium 2200, or the nonlinear penalty of the first gain medium 2100 is the same as the nonlinear penalty of the second gain medium 2200. This is not limited in this application.

Optionally, the saturated output power of the first gain medium 2100 is the same as or different from saturated output power of the second gain medium 2200. This is not limited in this application.

There is one or more second gain media 2200. This is not limited in this application. If there are a plurality of second gain media 2200, the plurality of second gain media 2200 are connected to the first gain medium 2100 to form a multi-stage amplification structure.

Optionally, as shown in FIG. 2, the optical amplifier 2000 further includes a variable optical attenuator VOA. The VOA is located on a link that is between the first multiplexer/demultiplexer 2300 and the second multiplexer/demultiplexer 2400 and that is used to transmit the first gain clamping light. The VOA herein is configured to adjust power of the first gain clamping light, to match an optimal power point of gain clamping on the first gain medium 2100. In this way, NF performance of the optical amplifier 2000 is ensured as much as possible (a decrease of a signal-to-noise ratio at an output end of the optical amplifier 2000 is suppressed as much as possible) on the premise that the power of the first gain clamping light is as large as possible (a gain clamping effect is ensured).

Optionally, a filter is further included on the link that is between the first multiplexer/demultiplexer 2300 and the second multiplexer/demultiplexer 2400 and that is used to transmit the first gain clamping light. The filter is configured to filter out gain clamping light of a target band. The filter may be a wide band-pass filter (wide band-pass filter, WBPF) or a narrow band-pass filter (narrow band-pass filter, NBPF). This is not limited in this application.

Alternatively, the filter may be integrated into the first multiplexer/demultiplexer 2300 or the second multiplexer/demultiplexer 2400, to simplify the structure of the optical amplifier and reduce costs. This is not limited in this application.

Optionally, in any structure in embodiments of this application, the optical amplifier 2000 further includes a gain flat filter (gain flat filter, GFF) located on an output side of the first gain medium 2100 (for example, located on a right side of the first gain medium 2100 in the figure). The GFF is configured to perform gain flat filtering on the target light, so that an output optical signal of the optical amplifier 2000 has a flat waveform.

Optionally, in any structure in embodiments of this application, the optical amplifier 2000 further includes a gain flat filter GFF located on an input side of the second gain medium 2200 (for example, located on the left side of the second gain medium 2200 in the figure). The GFF is configured to perform gain flat filtering on the amplified target light, so that an output optical signal of the optical amplifier 2000 has a flat waveform.

Optionally, in any embodiment of this application, the optical amplifier 2000 further includes more components, for example, an isolator, a pump light source, a VOA, a coupler, a PD, a multiplexer/demultiplexer, a filter, or a GFF. This is not limited in this application.

The target light output by the first gain medium 2100 includes the second optical signal in the communication band and light outside the communication band. A connection relationship between the first gain medium 2100 and the second gain medium 2200 is not limited in embodiments of this application, so as to implement different operations on the light outside the communication band by using different connection relationships. The following describes a plurality of structures of the optical amplifier 2000 provided in embodiments of this application based on different manners of processing the light outside the communication band.
1. Filter out the light outside the communication band in the target light.

As shown in FIG. 3, the optical amplifier 2000 further includes a fifth multiplexer/demultiplexer. The fifth multiplexer/demultiplexer is located between the first gain medium 2100 and the second gain medium 2200. The first gain medium 2100 is further configured to output the target light to the fifth multiplexer/demultiplexer. The fifth multiplexer/demultiplexer is configured to: split the target light into the second optical signal in the communication band and the light outside the communication band, filter out the light outside the communication band, and output the second optical signal to the second gain medium 2200.

The fifth multiplexer/demultiplexer is mainly configured to filter out the light outside the communication band from the target light. Similarly, in another structure in this embodiment of this application, another gain medium can also be connected to a multiplexer/demultiplexer. The multiplexer/demultiplexer is configured to filter out light outside a communication band from light from the gain medium. This is not limited in this application.

In this embodiment of this application, the first multiplexer/demultiplexer 2300 is configured to separate the first gain clamping light from the target light amplified through the second gain medium 2200. Optionally, the first gain clamping light may be ASE light in forward light/backward light of the second gain medium 2200, that is, the forward ASE light or the backward ASE light of the second gain medium 2200.

In embodiments of this application, the forward light is output light in a same direction as a signal transmission direction, and the backward light is output light in a direction opposite to the signal transmission direction. A flow direction of the optical signal is a direction from the second multiplexer/demultiplexer 2400 to the first gain medium 2100 to the second gain medium 2200. In the figure, the optical signal flows through the second gain medium 2200 from left to right. Therefore, a right side of the second gain medium 2200 is referred to as an output side (also a side from which the forward light is emitted) of the second gain medium, and the left side is referred to as the input side (also a side from which the backward light is emitted).

Optionally, if the first multiplexer/demultiplexer 2300 separates the first gain clamping light from the forward light of the second gain medium 2200, as shown in FIG. 3, the first multiplexer/demultiplexer 2300 is located on the output side (the right side in the figure) of the second gain medium 2200, so that the first multiplexer/demultiplexer 2300 receives the forward light from the second gain medium 2200.

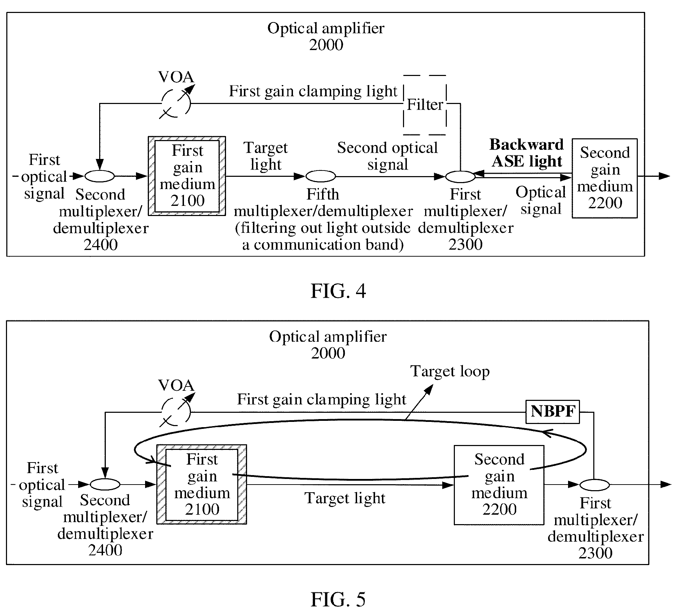

If the first multiplexer/demultiplexer 2300 separates the first gain clamping light from the backward light of the second gain medium 2200, as shown in FIG. 4, the first multiplexer/demultiplexer 2300 is located on the input side (the left side in the figure) of the second gain medium 2200, so that the first multiplexer/demultiplexer 2300 receives the backward light (the backward ASE light) from the second gain medium 2200. In this structure, the first multiplexer/demultiplexer 2300 is further configured to transmit the optical signal in the communication band, that is, the second optical signal, to the second gain medium 2200.

For ease of description, the following uses an example in which the first multiplexer/demultiplexer 2300 is located on the output side of the second gain medium 2200, which does not limit a position relationship between the first multiplexer/demultiplexer 2300 and the second gain medium 2200.

2. Generate laser light based on the light outside the communication band in the target light.

As shown in FIG. 5, in an optional structure, the first gain medium 2100 is directly connected to the second gain medium 2200. The first gain medium 2100 is further configured to output the target light to the second gain medium 2200. The second gain medium 2200 is configured to: amplify the target light, and output the target light amplified through the second gain medium to the first multiplexer/demultiplexer 2300.

In this structure, the optical amplifier 2000 includes a target loop. The target loop includes the second multiplexer/demultiplexer 2400, the first gain medium 2100, the second gain medium 2200, and the first multiplexer/demultiplexer 2300. The target loop is configured to transmit the first gain clamping light.

The target loop further includes a narrow band-pass filter NBPF. The NBPF is configured to control a bandwidth of the first gain clamping light, to generate the laser light on the target loop based on the first gain clamping light.

As shown in FIG. 5, the NBPF is located on the link that is between the first multiplexer/demultiplexer 2300 and the second multiplexer/demultiplexer 2400 and that is used to transmit the first clamping light. Alternatively, the NBPF may be located at another position of the target loop, for example, located between the first gain medium 2100 and the second gain medium 2200, or integrated on a multiplexer/demultiplexer in the target loop (for example, integrated on the first multiplexer/demultiplexer 2300 or the second multiplexer/demultiplexer 2400). This is not limited in this application.

In this embodiment of this application, the first gain clamping light is transmitted in the target loop. The bandwidth of the first gain clamping light is controlled by using the NBPF, so that the laser light can be generated on the target loop based on the first gain clamping light. Because intensity of the laser light (the first gain clamping light) is high, the first gain clamping light outside the communication band and the first optical signal in the communication band may preempt energy of the pump light. If a quantity of beams of the optical signal suddenly changes (for example, from 120 wavelengths to 10 wavelengths), the first gain clamping light may be used to preempt the energy of the pump light, to prevent the sudden change of energy of the optical signal on the gain medium, thereby preventing transient overshoot.

Optionally, in the embodiment shown in FIG. 5, the optical amplifier 2000 may further include a pump light source (not shown in the figure) connected to the second gain medium 2200. The pump light source is configured to emit pump light of the second gain medium 2200. The second gain medium 2200 is configured to amplify the target light based on the pump light.

3. Use the light outside the communication band in the target light as pump light of a subsequent gain medium.

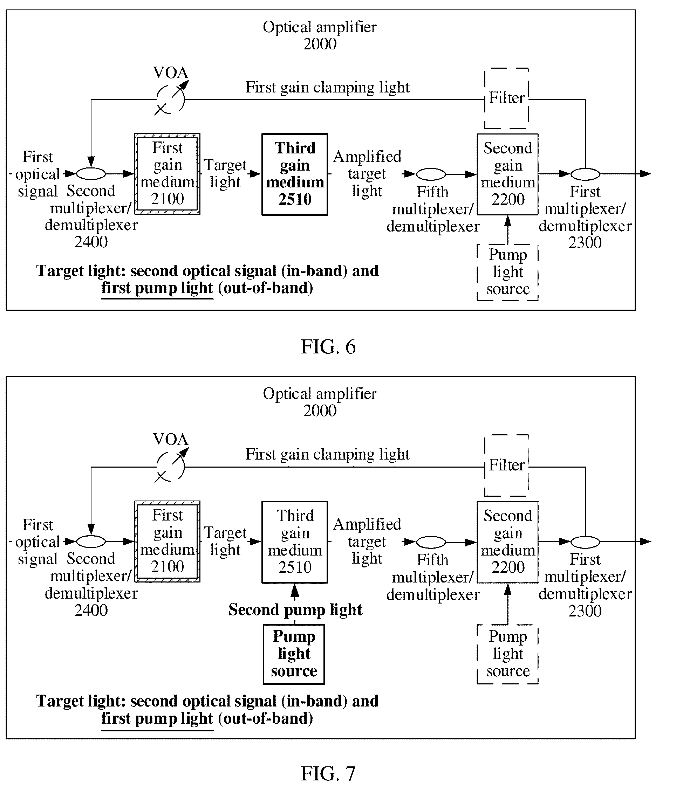

As shown in FIG. 6, the optical amplifier 2000 further includes the target gain medium 2500. The target gain medium 2500 in this structure is a third gain medium 2510. The first gain medium 2100, the third gain medium 2510, and the second gain medium 2200 are sequentially connected.

The third gain medium 2510 is configured to receive the target light from the first gain medium 2100. In this embodiment, the light outside the communication band (that is, out-of-band) in the target light is referred to as the first pump light, and the light in the communication band (that is, in-band) in the target light is referred to as the second optical signal. The third gain medium 2510 is further configured to: amplify the second optical signal based on the first pump light, and output the amplified target light to the second gain medium 2200.

The second gain medium 2200 is configured to: amplify the target light amplified through the third gain medium 2510, and output the amplified target light to the first multiplexer/demultiplexer 2300.

The first multiplexer/demultiplexer 2300 is specifically configured to separate the first gain clamping light from the target light amplified through the third gain medium 2510 and the second gain medium 2200.

In this embodiment of this application, the third gain medium 2510 amplifies the second optical signal by using the first pump light outside the communication band in the target light, further improving utilization of the light outside the communication band. This structure can reduce an optical power requirement of the pump light source of the third gain medium 2510 and reduce energy consumption. Alternatively, the pump light source of the third gain medium 2510 can be omitted, simplifying a device structure.

Optionally, as shown in FIG. 6, the fifth multiplexer/demultiplexer is disposed between the third gain medium 2510 and the second gain medium 2200. The fifth multiplexer/demultiplexer is configured to filter out, from the target light amplified through the third gain medium 2510, the light outside the communication band.

Optionally, as shown in FIG. 6, the optical amplifier 2000 further includes a pump light source connected to the second gain medium 2200. The pump light source is configured to emit pump light of the second gain medium 2200. The second gain medium 2200 is configured to amplify, based on the pump light, the target light amplified through the third gain medium 2510. In any embodiment of this application, the optical amplifier 2000 may include a pump light source connected to the second gain medium 2200. This is not limited in this application.

Optionally, in any structure including the third gain medium 2510 in embodiments of this application, the optical amplifier 2000 further includes a gain flat filter GFF located on an input side of the third gain medium 2510 (for example, located on a left side of the third gain medium 2510 in the figure). The GFF is configured to perform gain flat filtering on light input into the third gain medium 2510, so that an output optical signal of the optical amplifier 2000 has a flat waveform.

Optionally, the third gain medium 2510 may further amplify the second optical signal by using other pump light. As shown in FIG. 7, the optical amplifier 2000 further includes a pump light source connected to the third gain medium 2510. The pump light source is configured to emit the second pump light. The third gain medium 2510 is configured to: perform multiplexing on the second pump light and the first pump light to obtain target pump light, and amplify the second optical signal based on the target pump light.

In this embodiment of this application, the third gain medium 2510 can match optimal pump light power of the third gain medium 2510 by using the second pump light, to supplement a difference between optical power of the first pump light and the optimal pump light power, thereby improving an amplification effect of the second optical signal. Alternatively, the third gain medium 2510 can adjust total power of pump light input to the third gain medium 2510 by using the pump light source, so as to match different gain requirements, implementing gain adjustment of the entire optical amplifier 2000.

Optionally, power of the pump light source connected to the second gain medium 2200 is adjustable. Different gains of the optical amplifier 2000 can be locked by adjusting the power of the pump light source.

In the embodiments shown in FIG. 2 to FIG. 6, because the first clamping light is the forward ASE light of the second gain medium 2200, the first multiplexer/demultiplexer 2300 is located on the output side (the right side in the figure) of the second gain medium 2200. Optionally, if the first clamping light is the backward ASE light of the second gain medium 2200, the first multiplexer/demultiplexer 2300 is located on the input side (the left side in the figure) of the second gain medium 2200.

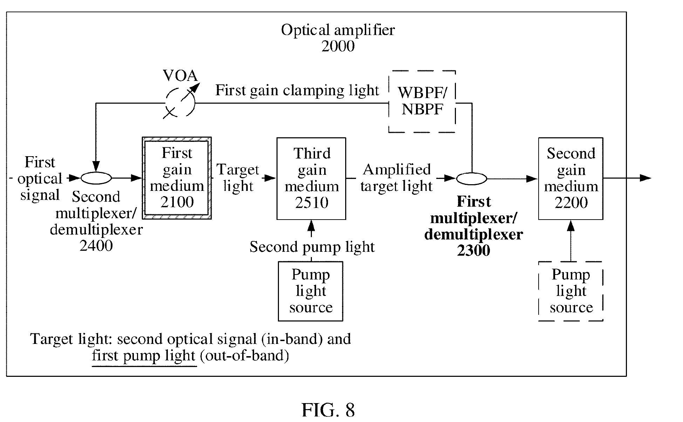

A position of the first multiplexer/demultiplexer 2300 is not limited in embodiments of this application. If the first multiplexer/demultiplexer 2300 in the embodiment shown in FIG. 7 is moved to the left side of the second gain medium 2200, the structure of the optical amplifier 2000 is simpler. As shown in FIG. 8, the first multiplexer/demultiplexer 2300 may be located between the third gain medium 2510 and the second gain medium 2200. The first multiplexer/demultiplexer 2300 may include one common port and a plurality of branch ports.

In the structure shown in FIG. 8, the common port of the first multiplexer/demultiplexer 2300 is connected to different components to implement different functions.

In an example, the common port of the first multiplexer/demultiplexer 2300 is connected to the second gain medium 2200, and the plurality of branch ports are respectively connected to the third gain medium 2510 and the second multiplexer/demultiplexer 2400. In this case, in the target light amplified through the third gain medium 2510, the optical signal in the communication band is transmitted to the second gain medium 2200 via the first multiplexer/demultiplexer 2300. The backward ASE light emitted by the second gain medium 2200 is transmitted to the first gain medium 2100 and the third gain medium 2510 via the first multiplexer/demultiplexer 2300 and the second multiplexer/demultiplexer 2400. Transmission of the light outside the communication band in this direction (a flow direction of the optical signal, which is from left to right in the figure) is truncated at the first multiplexer/demultiplexer 2300, and is not transmitted from the third gain medium 2510 to the second gain medium 2200. In this structure, the first gain clamping light is the backward ASE light of the second gain medium 2200.

Optionally, in this structure, between the first multiplexer/demultiplexer 2300 and the second multiplexer/demultiplexer 2400, a filter (as shown in a dashed line box in the figure) on a transmission link of the first gain clamping light is a WBPF. In this case, a spectrum of the gain clamping light is wide and the power is high, so that the gain clamping effect is better. In this way, the saturated output power of the first gain medium 2100 is better improved, and the nonlinear penalty is reduced.

Optionally, in this structure, between the first multiplexer/demultiplexer 2300 and the second multiplexer/demultiplexer 2400, a filter (as shown in a dashed line box in the figure) on a transmission link of the first gain clamping light is an NBPF. In this case, a spectrum of the gain clamping light is narrow, so that the gain clamping light forms narrow-band laser light, thereby reducing the nonlinear penalty and suppressing transient overshoot of the signal.

**In** another example, the common port of the first multiplexer/demultiplexer 2300 is connected to the third gain medium 2510, and the plurality of branch ports are respectively connected to the second gain medium 2200 and the second multiplexer/demultiplexer 2400. In this case, in the target light amplified through the third gain medium 2510, the optical signal in the communication band is transmitted to the second gain medium 2200 via the first multiplexer/demultiplexer 2300, and the first gain clamping light outside the communication band is transmitted to the second multiplexer/demultiplexer 2400 via the first multiplexer/demultiplexer 2300. Transmission of the light outside the communication band in an optical signal transmission direction (from left to right in the figure) is truncated at the first multiplexer/demultiplexer 2300, and is not further transmitted to the second gain medium 2200. In other words, in this structure, the light outside the communication band is transmitted in a loop formed by the third gain medium 2510, the first multiplexer/demultiplexer 2300, the second multiplexer/demultiplexer 2400, and the first gain medium 2100.

Optionally, in this structure, between the first multiplexer/demultiplexer 2300 and the second multiplexer/demultiplexer 2400, a filter (as shown in a dashed line box in the figure) on a transmission link of the first gain clamping light is an NBPF. In this case, the laser light in the loop formed by the third gain medium 2510, the first multiplexer/demultiplexer 2300, the second multiplexer/demultiplexer 2400, and the first gain medium 2100 is generated based on the first gain clamping light, thereby reducing the nonlinear penalty and suppressing transient overshoot of the signal.

Optionally, if the third gain medium 2510 is placed behind the second gain medium 2200 in the optical signal transmission direction, different functions can also be implemented by connecting the common port of the first multiplexer/demultiplexer 2300 to different components.

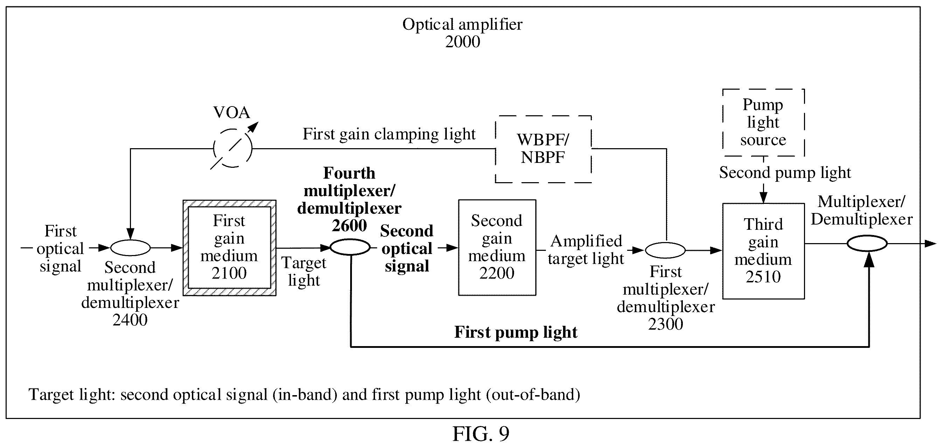

A specific structure is shown in FIG. 9. In this structure, the optical amplifier 2000 further includes a fourth multiplexer/demultiplexer 2600 and the third gain medium 2510. The first gain medium 2100, the fourth multiplexer/demultiplexer 2600, the second gain medium 2200, and the third gain medium 2510 are sequentially connected. The fourth multiplexer/demultiplexer 2600 is connected to the third gain medium 2510 via a rightmost multiplexer/demultiplexer in FIG. 9.

The fourth multiplexer/demultiplexer 2600 is configured to receive the target light. In the target light, the light outside the communication band (that is, out-of-band) is the first pump light, and the light in the communication band (that is, in-band) is the second optical signal. The fourth multiplexer/demultiplexer 2600 is further configured to: output the first pump light to the rightmost multiplexer/demultiplexer in FIG. 9, to output the first pump light to the third gain medium 2510, and output the second optical signal to the second gain medium 2200.

The second gain medium 2200 is configured to: amplify the second optical signal, and output the amplified target light to the third gain medium 2510. The third gain medium 2510 is configured to amplify, based on the first pump light, the target light amplified through the second gain medium 2200.

In the structure shown in FIG. 9, the first multiplexer/demultiplexer 2300 may be located between the second gain medium 2200 and the third gain medium 2510. The first multiplexer/demultiplexer 2300 may include one common port and a plurality of branch ports.

In the structure shown in FIG. 9, for a structure of the first multiplexer/demultiplexer 2300, refer to the embodiment shown in FIG. 8. Similar to FIG. 8, if the common port of the first multiplexer/demultiplexer 2300 in FIG. 9 is connected to the second gain medium 2200, the first gain clamping light is the forward ASE light of the second gain medium 2200, and the entire structure does not form a loop for the first gain clamping light. If the common port of the first multiplexer/demultiplexer 2300 is connected to the third gain medium 2510, the first gain clamping light is backward ASE light of the third gain medium 2510, and the entire structure forms a loop for the first gain clamping light to generate the laser light. For advantages of forming a loop or not forming a loop and whether the NBPF or the WBPF is connected, refer to the descriptions of the embodiment shown in FIG. 8. Details are not described herein again.

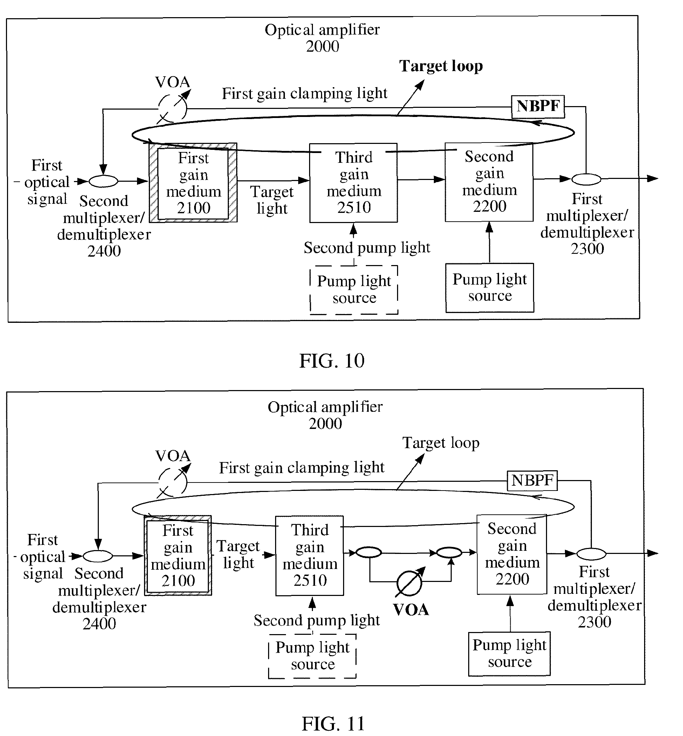

Optionally, if the fifth multiplexer/demultiplexer in FIG. 7 is removed, the optical amplifier 2000 includes a target loop for the first gain clamping light. As shown in FIG. 10, the target loop includes the second multiplexer/demultiplexer 2400, the first gain medium 2100, the third gain medium 2510, the second gain medium 2200, and the first multiplexer/demultiplexer 2300.

The target loop further includes a narrow band-pass filter NBPF. The NBPF is configured to control a bandwidth of the first gain clamping light, to generate the laser light on the target loop based on the first gain clamping light.

As shown in FIG. 10, the NBPF is located on the link that is between the first multiplexer/demultiplexer 2300 and the second multiplexer/demultiplexer 2400 and that is used to transmit the first gain clamping light. Optionally, the NBPF may also be located at another position of the target loop, for example, located between the first gain medium 2100 and the second gain medium 2200, or integrated on a multiplexer/demultiplexer in the target loop (for example, integrated on the first multiplexer/demultiplexer 2300 or the second multiplexer/demultiplexer 2400). This is not limited in this application.

In this embodiment of this application, the laser light is generated on the target loop based on the first gain clamping light. The first gain clamping light is used to preempt the energy of the pump light, to prevent the sudden change of the energy of the optical signal on the gain medium, thereby preventing transient overshoot.

Optionally, the structure of the optical amplifier 2000 shown in FIG. 10 may be used for an optical amplifier with a fixed gain. Optionally, if the structure shown in FIG. 10 is deformed to some extent, an optical amplifier with an adjustable gain may be obtained. A specific structure is shown in FIG. 11. In this structure, the transmission link between the third gain medium 2510 and the second gain medium 2200 is divided into two branches via two multiplexers/demultiplexers. One branch is configured to transmit the light outside the communication band, and the link is directly connected through an optical fiber (where two ends of the optical fiber are respectively connected to the third gain medium 2510 and the second gain medium 2200 via the multiplexer/demultiplexer). The other branch is configured to transmit the optical signal in the communication band, and a VOA on the link is configured to adjust a gain of the optical amplifier 2000 on the optical signal.

In this embodiment of this application, the optical signal in the communication band is transmitted among the third gain medium 2510, the VOA, and the second gain medium 2200, and gain adjustment of the entire optical amplifier 2000 may be implemented by using the VOA, so that the gain of the optical amplifier 2000 in this structure is adjustable.

It should be noted that, in this embodiment of this application, the optical amplifier 2000 with an adjustable gain means that a shape of a gain spectrum (representing gain values of the optical amplifier 2000 at different wavelengths) of the entire optical amplifier 2000 remains unchanged or slightly changes under different gain conditions (that is, different gain values of the optical amplifier 2000). Correspondingly, the optical amplifier 2000 with a fixed gain means that a shape of a gain spectrum of the entire optical amplifier 2000 changes significantly (for example, a slope of the gain spectrum changes significantly) under different gain conditions.

Similarly, in the structure shown in FIG. 5, if a structure in which an optical fiber and a VOA are connected in parallel is set between the first gain medium 2100 and the second gain medium 2200, the gain of the entire optical amplifier 2000 is adjustable.

Optionally, in the structures shown in FIG. 6 to FIG. 11, the first gain medium 2100 is an SOA or a quantum dot optical amplifier with a high nonlinear penalty, and the second gain medium 2200 and the third gain medium 2510 each are an EDF with a low nonlinear penalty.

In embodiments of this application, in addition to being used as the pump light of the subsequent gain medium, the gain clamping light may be further used for gain clamping of the subsequent gain medium.

4. Use the light outside the communication band in the target light for gain clamping of the subsequent gain medium.

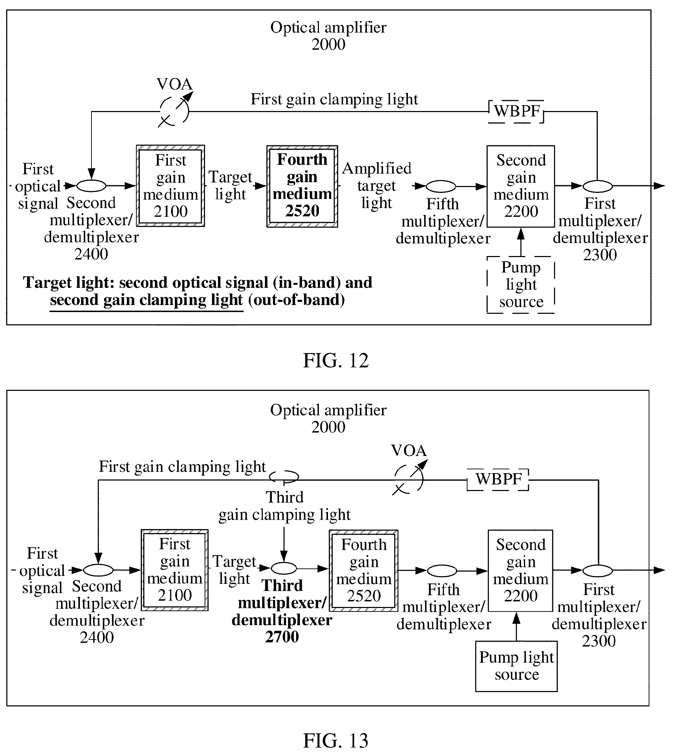

Optionally, the optical amplifier 2000 further includes the target gain medium 2500. The target gain medium 2500 in this structure is a fourth gain medium 2520. The light outside the communication band in the target light is used to implement gain clamping on the optical signal on the fourth gain medium 2520. A specific structure is shown in FIG. 12. In this structure, the first gain medium 2100, the fourth gain medium 2520, and the second gain medium 2200 are sequentially connected.

The fourth gain medium 2520 is configured to receive the target light from the first gain medium 2100. In this embodiment, the light in the communication band (that is, in-band) in the target light is referred to as the second optical signal, and the light outside the communication band (that is, out-of-band) in the target light is referred to as the second gain clamping light. The fourth gain medium 2520 is further configured to amplify the second optical signal. In a process of amplifying the second optical signal through the fourth gain medium 2520, the fourth gain medium 2520 performs gain clamping on the second optical signal based on the second gain clamping light. The fourth gain medium 2520 is further configured to output the amplified target light to the second gain medium 2200.

The second gain medium 2200 is configured to: amplify the target light amplified through the fourth gain medium 2520, and output the amplified target light to the first multiplexer/demultiplexer 2300.

The first multiplexer/demultiplexer 2300 is specifically configured to separate the first gain clamping light from the target light amplified through the fourth gain medium 2520 and the second gain medium 2200.

In this embodiment of this application, the second gain clamping light is the light outside the communication band in the target light. In a process of amplifying the second optical signal, the fourth gain medium 2520 implements gain clamping on the second optical signal by using the second gain clamping light. In other words, the fourth gain medium 2520 uses the light that is outside the communication band and that should be discarded in the target light for gain clamping. Performing gain clamping on the second optical signal can improve saturated output power of the fourth gain medium 2520, and reduce a nonlinear penalty of the fourth gain medium 2520, thereby improving performance of the entire optical amplifier 2000. Further, the light that is outside the communication band and that should be discarded in the communication process is utilized, so that utilization of light of the entire optical amplifier 2000 can be improved, and a requirement for an external light source (that is, a light source of the second gain clamping light) is reduced.

If optimal gain clamping power of the fourth gain medium 2520 is high, the gain clamping light amplified through the first gain medium 2100 can match the optimal gain clamping power of the fourth gain medium 2520. No additional component is required to provide high-power gain clamping light, and a better gain clamping effect can be achieved on the fourth gain medium 2520.

Optionally, in addition to the first gain clamping light, the first multiplexer/demultiplexer 2300 may further separate another channel of gain clamping light (third gain clamping light). Two channels of gain clamping light are respectively used to implement gain clamping on the optical signal on the first gain medium 2100 and the fourth gain medium 2520. A specific structure is shown in FIG. 13.

In this structure, the optical amplifier 2000 further includes a third multiplexer/demultiplexer 2700 and the target gain medium 2500. The target gain medium 2500 in this structure is the fourth gain medium 2520. The first gain medium 2100, the third multiplexer/demultiplexer 2700, the fourth gain medium 2520, and the second gain medium 2200 are sequentially connected. The third multiplexer/demultiplexer 2700 is further connected to the first multiplexer/demultiplexer 2300.

The first multiplexer/demultiplexer 2300 is further configured to: separate the third gain clamping light from the target light amplified through the second gain medium 2200, and output the third gain clamping light to the third multiplexer/demultiplexer 2700.

The third multiplexer/demultiplexer 2700 is configured to: receive the target light, and output the third gain clamping light and the target light to the fourth gain medium 2520 in a coupling manner.

The fourth gain medium 2520 is configured to: amplify the target light obtained by the third multiplexer/demultiplexer through coupling 2700, perform gain clamping on the target light based on the third gain clamping light, and output the amplified target light to the second gain medium 2200.

The second gain medium 2200 is configured to: amplify the target light amplified through the fourth gain medium 2520, and output the amplified target light to the first multiplexer/demultiplexer 2300.

The first multiplexer/demultiplexer 2300 is specifically configured to separate the first gain clamping light from the target light amplified through the fourth gain medium 2520 and the second gain medium 2200.

In this embodiment of this application, the first multiplexer/demultiplexer 2300 separates the first gain clamping light and the third gain clamping light from the target light amplified through the second gain medium 2200. The two channels of gain clamping light are respectively used to implement gain clamping on the optical signal on the first gain medium 2100 and the fourth gain medium 2520. This can reduce nonlinear penalties of the first gain medium 2100 and the fourth gain medium 2520, and can improve utilization of the light outside the communication band.

Optionally, the optical amplifier 2000 further includes the fifth multiplexer/demultiplexer. The fifth multiplexer/demultiplexer is located between the fourth gain medium 2520 and the second gain medium 2200, and is configured to filter out, from the target light amplified through the fourth gain medium 2520, the light outside the communication band.

Optionally, a multiplexer/demultiplexer is further included at a split point at which the two channels of gain clamping light are transmitted to the second multiplexer/demultiplexer 2400 and the third multiplexer/demultiplexer 2700. In an implementation, the multiplexer/demultiplexer is based on a wavelength division principle. The multiplexer/demultiplexer demultiplexes the gain clamping light through wavelength division, so that the first gain clamping light of a first band in the target band (of the gain clamping light) is transmitted to the second multiplexer/demultiplexer 2400, and the third gain clamping light of a second band is transmitted to the third multiplexer/demultiplexer 2700. In another implementation, the multiplexer/demultiplexer is a power beam splitter. The multiplexer/demultiplexer implements matching of optimal gain clamping power of the first gain medium 2100 and the optimal gain clamping power of the fourth gain medium 2520 by controlling a power ratio of the two channels.

In the embodiments shown in FIG. 6 to FIG. 11, the light outside the communication band in the target light is used as the pump light source of the third gain medium. In the embodiments shown in FIG. 12 and FIG. 13, the light outside the communication band in the target light is used to implement gain clamping on the optical signal on the fourth gain medium. Optionally, the foregoing two structures may be combined, so that the gain clamping light is not only used as the pump light source of the subsequent gain medium, but also used to implement gain clamping on the optical signal on the subsequent gain medium. This is not limited in this application.

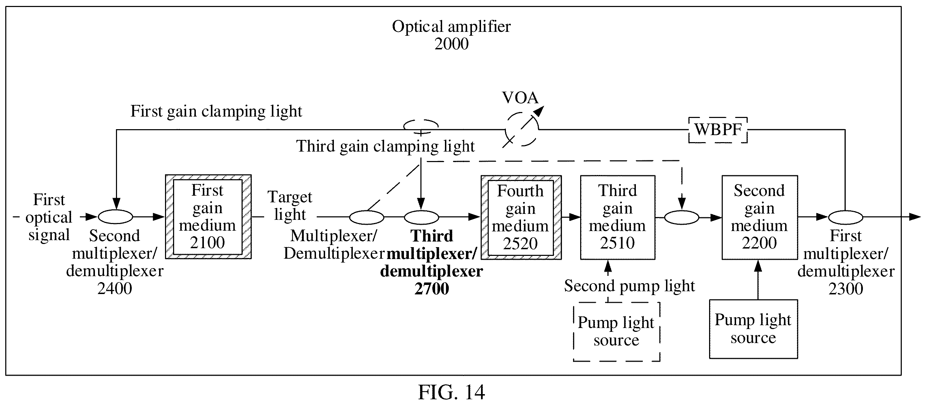

For example, a combined structure may be shown in FIG. 14. In this structure, after being amplified through the fourth gain medium 2520, the target light is input into the third gain medium 2510. The third gain medium 2510 may amplify the target light amplified through the fourth gain medium 2520, and use the light outside the communication band in the target light as the pump light to amplify the light in the communication band in the target light.

Optionally, in the structure shown in FIG. 14, a multiplexer/demultiplexer is further included behind the first gain medium 2100. The multiplexer/demultiplexer splits the target light from the first gain medium 2100 into the optical signal in the communication band and the light outside the communication band. The light outside the communication band is transmitted to the third gain medium 2510 along a dashed line, and is used as forward pump light of the third gain medium 2510. The optical signal in the communication band is transmitted to the third multiplexer/demultiplexer 2700.

Optionally, between the first gain medium 2100 and the fourth gain medium 2520, the multiplexer/demultiplexer and the third multiplexer/demultiplexer 2700 may alternatively be packaged together for use. This is not limited in this application.

The target light amplified through the fourth gain medium 2520 is directly transmitted to the third gain medium 2510, and the light outside the communication band in the target light is used as backward pump light of the third gain medium 2510.

Optionally, in the structure shown in FIG. 12, if the third gain medium 2510 is additionally disposed behind the fourth gain medium 2520, the third gain medium 2510 may use the light outside the communication band in the target light amplified through the fourth gain medium as the pump light, to amplify the optical signal in the communication band in the target light. In this way, utilization of light of the optical amplifier 2000 is improved.

Optionally, in the structures shown in FIG. 12 to FIG. 14, the first gain medium 2100 and the fourth gain medium 2520 each are an SOA or a quantum dot optical amplifier with a high nonlinear penalty, and the second gain medium 2200 and the third gain medium 2510 each are an EDF with a low nonlinear penalty.

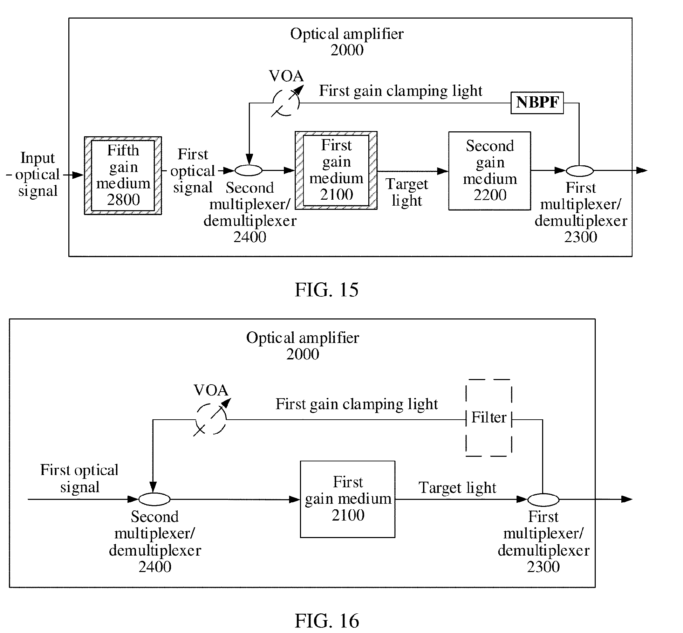

Optionally, if a fifth gain medium is additionally disposed before the second multiplexer/demultiplexer 2100, the fifth gain medium is configured to amplify the input optical signal of the optical amplifier 2000, to obtain the first optical signal. As shown in FIG. 15, the optical amplifier 2000 further includes a fifth gain medium 2800. The fifth gain medium 2800 is connected to the second multiplexer/demultiplexer 2400.

In this structure, the first optical signal is the optical signal obtained by amplifying the input optical signal of the optical amplifier. The fifth gain medium 2800 is configured to: receive and amplify the input signal of the optical amplifier 2000, to obtain the first optical signal, and output the first optical signal to the second multiplexer/demultiplexer 2400.

In this embodiment of this application, the input optical signal of the optical amplifier 2000 is amplified through the fifth gain medium 2800 before entering the second multiplexer/demultiplexer 2400, which can reduce an insertion loss of the optical signal due to the second multiplexer/demultiplexer 2400. Optionally, the fifth gain medium 2800 is a gain medium with good NF performance.

Optionally, the fifth gain medium 2800 is an SOA or a quantum dot optical amplifier with a high nonlinear penalty.

FIG. 15 shows the structure of the optical amplifier 2000 obtained by adding the fifth gain medium 2800 based on the structure shown in FIG. 5. It should be noted that FIG. 15 is merely an example, and does not limit the structure of the optical amplifier including the fifth gain medium 2800. For example, the fifth gain medium 2800 may alternatively be added to any structure in FIG. 2 to FIG. 4 and FIG. 6 to FIG. 14. This is not limited in this application.

Alternatively, if the optical amplifier 2000 does not include the fifth gain medium 2800, the first optical signal is the input optical signal of the optical amplifier 2000.

In embodiments of this application, if the first gain clamping light is directly separated from the target light output by the first gain medium 2100, a corresponding structure is shown in FIG. 16. In this structure, the optical amplifier 2000 includes the first gain medium 2100, the first multiplexer/demultiplexer 2300, and the second multiplexer/demultiplexer 2400. The second multiplexer/demultiplexer 2400, the first gain medium 2100, and the first multiplexer/demultiplexer 2300 are sequentially connected.

The second multiplexer/demultiplexer 2400 is configured to output, to the first gain medium 2100 in a coupling manner, the first optical signal and the first gain clamping light output by the first multiplexer/demultiplexer 2300. The first optical signal is the input optical signal of the optical amplifier 2000, or the first optical signal is the optical signal obtained by amplifying the input optical signal of the optical amplifier.

The first gain medium 2100 is configured to: amplify the first optical signal, and perform gain clamping on the first optical signal based on the first gain clamping light, to obtain the target light.

The first multiplexer/demultiplexer 2300 is configured to separate the first gain clamping light from the target light.

In this embodiment of this application, the first gain clamping light is the light that is separated from the target light (generated after the first optical signal is amplified through the first gain medium 2100) and that is outside the communication band. In addition, in a process of amplifying the first optical signal, the first gain medium 2100 implements gain clamping on the first optical signal by using the first gain clamping light. In other words, the first gain medium 2100 uses the light that is outside the communication band and that should be discarded in a communication process for gain clamping. Performing gain clamping on the first optical signal can improve saturated output power of the first gain medium 2100, and reduce a nonlinear penalty of the first gain medium 2100, thereby improving performance of the entire optical amplifier 2000. Further, the light that is outside the communication band and that should be discarded in the communication process is utilized, so that utilization of light of the entire optical amplifier 2000 can be improved, and a requirement for an external light source (that is, a light source of the first gain clamping light) is reduced.

Optionally, the first gain medium 2100 is a semiconductor amplifier SOA, a planar waveguide gain medium (for example, a lithium niobate LiNbO3), or a doped fiber (for example, an erbium doped fiber EDF or a bismuth doped fiber BDF). This is not limited in this application.

If the first optical signal is the input optical signal of the optical amplifier 2000, the second multiplexer/demultiplexer 2400 is connected to an input port of the optical amplifier 2000. The input port is configured to receive the input optical signal of the optical amplifier 2000, and output the input optical signal to the second multiplexer/demultiplexer 2400.

If the first optical signal is the optical signal obtained by amplifying the input optical signal of the optical amplifier, the optical amplifier further includes the second gain medium. The second gain medium is connected to the second multiplexer/demultiplexer 2400. The second gain medium is configured to: receive and amplify the input optical signal of the optical amplifier 2000, to obtain the first optical signal, and output the first optical signal to the second multiplexer/demultiplexer 2400. For detailed descriptions of the second gain medium, refer to the descriptions of the fifth gain medium 2800 in the embodiment shown in FIG. 15. Details are not described herein again.

In this embodiment of this application, the input optical signal of the optical amplifier 2000 is amplified through the second gain medium before entering the second multiplexer/demultiplexer 2400, which can reduce an insertion loss of the optical signal due to the second multiplexer/demultiplexer 2400.

Optionally, in the structure of the optical amplifier 2000 shown in FIG. 15, a filter (represented by a dashed line box in the figure) on the link that is between the first multiplexer/demultiplexer 2300 and the second multiplexer/demultiplexer 2400 and that is used to transmit the first gain clamping light is an NBPF. The NBPF is included in a target loop. The target loop includes the second multiplexer/demultiplexer 2400, the first gain medium 2100, and the first multiplexer/demultiplexer 2300. The target loop is configured to transmit the first gain clamping light. The narrow band-pass filter NBPF is configured to control a bandwidth of the first gain clamping light, to generate the laser light on the target loop based on the first gain clamping light.

In this embodiment of this application, the laser light is generated on the target loop based on the first gain clamping light. The first gain clamping light is used to preempt the energy of the pump light, to prevent the sudden change of the energy of the optical signal on the gain medium, thereby preventing transient overshoot.

The embodiments shown in FIG. 2 to FIG. 16 each describe the structure of the optical amplifier 2000 according to embodiments of this application. Embodiments of this application further protect an optical communication device including the optical amplifier 2000. Optionally, the optical communication device is an optical transmitting device, an optical receiving device, a relay amplification device, or the like. This is not limited in this application.

The optical amplifier 2000 described in FIG. 2 to FIG. 16 is used in the optical communication system shown in FIG. 1, that is, the optical communication system provided in embodiments of this application. Optionally, the optical amplifier 2000 is an independent optical amplifier in an optical communication network, or an optical amplifier in the optical communication device in the optical communication system. This is not limited in this application.

In some embodiments provided in this application, it should be understood that the disclosed system, apparatus, and method may be implemented in another manner. For example, the described apparatus embodiments are merely examples. For example, division into the units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

## Claims

1. An optical amplifier, comprising a first gain medium, a second gain medium, a first multiplexer/demultiplexer, and a second multiplexer/demultiplexer, wherein the second multiplexer/demultiplexer is connected to the first gain medium;
the second multiplexer/demultiplexer is configured to output, to the first gain medium in a coupling manner, a first optical signal and first gain clamping light output by the first multiplexer/demultiplexer, wherein the first optical signal is an input optical signal of the optical amplifier, or is an optical signal obtained by amplifying the input optical signal of the optical amplifier;
the first gain medium is configured to: amplify the first optical signal, and perform gain clamping on the first optical signal based on the first gain clamping light, to obtain target light, wherein the target light is light obtained by amplifying the first optical signal through the first gain medium;
the second gain medium is configured to amplify the target light or the target light amplified through a target gain medium; and
the first multiplexer/demultiplexer is configured to separate the first gain clamping light from the target light amplified through the second gain medium.

2. The optical amplifier according to claim 1, wherein the first gain medium is connected to the second gain medium;
the first gain medium is further configured to output the target light to the second gain medium; and
the second gain medium is configured to: amplify the target light, and output the amplified target light to the first multiplexer/demultiplexer.

3. The optical amplifier according to claim 1, wherein the optical amplifier further comprises the target gain medium, the target gain medium comprises a third gain medium, and the first gain medium, the third gain medium, and the second gain medium are sequentially connected;
the third gain medium is configured to: receive the target light, amplify a second optical signal based on first pump light, and output the amplified target light to the second gain medium, wherein the first pump light is light outside a communication band in the target light, and the second optical signal is light in the communication band in the target light;
the second gain medium is configured to: amplify the target light amplified through the third gain medium, and output the amplified target light to the first multiplexer/demultiplexer; and
the first multiplexer/demultiplexer is specifically configured to separate the first gain clamping light from the target light amplified through the third gain medium and the second gain medium.

4. The optical amplifier according to claim 3, wherein the optical amplifier further comprises a pump light source, and the pump light source is connected to the third gain medium;
the pump light source is configured to provide second pump light; and
the third gain medium is configured to: perform multiplexing on the second pump light and the first pump light to obtain target pump light, and amplify the second optical signal based on the target pump light.

5. The optical amplifier according to claim 1, wherein the optical amplifier further comprises the target gain medium, the target gain medium comprises a fourth gain medium, and the first gain medium, the fourth gain medium, and the second gain medium are sequentially connected;
the fourth gain medium is configured to: receive the target light, amplify a second optical signal, perform gain clamping on the second optical signal based on second gain clamping light, and output the amplified target light to the second gain medium, wherein the second optical signal is light in a communication band in the target light, and the second gain clamping light is light outside the communication band in the target light;
the second gain medium is configured to: amplify the target light amplified through the fourth gain medium, and output the amplified target light to the first multiplexer/demultiplexer; and
the first multiplexer/demultiplexer is specifically configured to separate the first gain clamping light from the target light amplified through the fourth gain medium and the second gain medium.

6. The optical amplifier according to claim 1, wherein the optical amplifier further comprises a third multiplexer/demultiplexer and the target gain medium, the target gain medium comprises a fourth gain medium, the first gain medium, the third multiplexer/demultiplexer, the fourth gain medium, and the second gain medium are sequentially connected, and the third multiplexer/demultiplexer is further connected to the first multiplexer/demultiplexer;
the first multiplexer/demultiplexer is further configured to: separate third gain clamping light from the target light amplified through the second gain medium, and output the third gain clamping light to the third multiplexer/demultiplexer;
the third multiplexer/demultiplexer is configured to: receive the target light, and output the third gain clamping light and the target light to the fourth gain medium in a coupling manner;
the fourth gain medium is configured to: amplify the target light obtained by the third multiplexer/demultiplexer through coupling, perform gain clamping on the target light based on the third gain clamping light, and output the amplified target light to the second gain medium;
the second gain medium is configured to: amplify the target light amplified through the fourth gain medium, and output the amplified target light to the first multiplexer/demultiplexer; and
the first multiplexer/demultiplexer is specifically configured to separate the first gain clamping light from the target light amplified through the fourth gain medium and the second gain medium.

7. The optical amplifier according to claim 1, wherein the optical amplifier further comprises the target gain medium, the target gain medium comprises a third gain medium and a fourth gain medium, and the first gain medium, the fourth gain medium, the third gain medium, and the second gain medium are sequentially connected;
the fourth gain medium is configured to: receive the target light, amplify a second optical signal, perform gain clamping on the second optical signal based on second gain clamping light, and output the amplified target light to the third gain medium, wherein the second optical signal is light in a communication band in the target light, and the second gain clamping light is light outside the communication band in the target light;
the third gain medium is configured to: receive the target light amplified through the fourth gain medium, amplify a third optical signal based on third pump light, and output the amplified target light to the second gain medium, wherein the third pump light is light outside the communication band in the target light amplified through the fourth gain medium, and the third optical signal is light in the communication band in the target light amplified through the fourth gain medium;
the second gain medium is configured to: amplify the target light amplified through the fourth gain medium and the third gain medium, and output the amplified target light to the first multiplexer/demultiplexer; and
the first multiplexer/demultiplexer is specifically configured to separate the first gain clamping light from the target light amplified through the fourth gain medium, the third gain medium, and the second gain medium.

8. The optical amplifier according to claim 7, wherein the optical amplifier further comprises a pump light source, and the pump light source is connected to the third gain medium;
the pump light source is configured to provide second pump light; and
the third gain medium is configured to: perform multiplexing on the second pump light and the third pump light to obtain target pump light, and amplify the third optical signal based on the target pump light.

9. The optical amplifier according to claim 1, wherein the optical amplifier further comprises a third multiplexer/demultiplexer and the target gain medium, the target gain medium comprises a third gain medium and a fourth gain medium, the first gain medium, the third multiplexer/demultiplexer, the fourth gain medium, the third gain medium, and the second gain medium are sequentially connected, and the third multiplexer/demultiplexer is further connected to the first multiplexer/demultiplexer;
the first multiplexer/demultiplexer is further configured to: separate third gain clamping light from the target light amplified through the second gain medium, and output the third gain clamping light to the third multiplexer/demultiplexer;
the third multiplexer/demultiplexer is configured to: receive the target light, and output the third gain clamping light and the target light to the fourth gain medium in a coupling manner;
the fourth gain medium is configured to: amplify the target light obtained by the third multiplexer/demultiplexer through coupling, perform gain clamping on the target light based on the third gain clamping light, and output the amplified target light to the third gain medium;
the third gain medium is configured to: receive the target light amplified through the fourth gain medium, amplify a fourth optical signal based on fourth pump light, and output the amplified target light to the second gain medium, wherein the fourth pump light is light outside a communication band in the target light amplified through the fourth gain medium, and the fourth optical signal is light in the communication band in the target light amplified through the fourth gain medium;
the second gain medium is configured to: amplify the target light amplified through the fourth gain medium and the third gain medium, and output the amplified target light to the first multiplexer/demultiplexer; and
the first multiplexer/demultiplexer is specifically configured to separate the first gain clamping light from the target light amplified through the fourth gain medium, the third gain medium, and the second gain medium.

10. The optical amplifier according to claim 9, wherein the optical amplifier further comprises a pump light source, and the pump light source is connected to the third gain medium;
the pump light source is configured to provide second pump light; and
the third gain medium is configured to: perform multiplexing on the second pump light and the fourth pump light to obtain target pump light, and amplify the fourth optical signal based on the target pump light.

11. The optical amplifier according to claim 1, wherein the optical amplifier further comprises a fourth multiplexer/demultiplexer and a third gain medium, the first gain medium, the fourth multiplexer/demultiplexer, the second gain medium, and the third gain medium are sequentially connected, and the fourth multiplexer/demultiplexer is further connected to the third gain medium;
the fourth multiplexer/demultiplexer is configured to: receive the target light, output first pump light to the third gain medium, and output a second optical signal to the second gain medium, wherein the first pump light is light outside a communication band in the target light, and the second optical signal is light in the communication band in the target light;
the second gain medium is configured to: amplify the second optical signal, and output the amplified target light to the third gain medium; and
the third gain medium is configured to amplify, based on the first pump light, the target light amplified through the second gain medium.

12. The optical amplifier according to any one of claims 1 to 11, wherein the optical amplifier further comprises a narrow band-pass filter;
the narrow band-pass filter is comprised in a target loop, the target loop comprises the second multiplexer/demultiplexer, the first gain medium, the second gain medium, and the first multiplexer/demultiplexer, and the target loop is configured to transmit the first gain clamping light; and
the narrow band-pass filter is configured to control a bandwidth of the first gain clamping light, to generate laser light on the target loop based on the first gain clamping light.

13. The optical amplifier according to any one of claims 1 to 12, wherein the optical amplifier further comprises a fifth gain medium, the fifth gain medium is connected to the second multiplexer/demultiplexer, and the first optical signal is the optical signal obtained by amplifying the input optical signal of the optical amplifier; and
the fifth gain medium is configured to: receive and amplify the input optical signal of the optical amplifier, to obtain the first optical signal, and output the first optical signal to the second multiplexer/demultiplexer.

14. The optical amplifier according to any one of claims 1 to 13, wherein a nonlinear penalty of the first gain medium is higher than a nonlinear penalty of the second gain medium.

15. The optical amplifier according to any one of claims 1 to 14, wherein the optical amplifier further comprises a variable optical attenuator VOA, and the VOA is located between the first multiplexer/demultiplexer and the second multiplexer/demultiplexer; and
the VOA is configured to adjust power of the first gain clamping light.

16. An optical amplifier, comprising a first gain medium, a first multiplexer/demultiplexer, and a second multiplexer/demultiplexer, wherein the second multiplexer/demultiplexer, the first gain medium, and the first multiplexer/demultiplexer are sequentially connected;
the second multiplexer/demultiplexer is configured to output, to the first gain medium in a coupling manner, a first optical signal and first gain clamping light output by the first multiplexer/demultiplexer, wherein the first optical signal is an input optical signal of the optical amplifier, or is an optical signal obtained by amplifying the input optical signal of the optical amplifier;
the first gain medium is configured to: amplify the first optical signal, and perform gain clamping on the first optical signal based on the first gain clamping light, to obtain target light; and
the first multiplexer/demultiplexer is configured to separate the first gain clamping light from the target light.

17. The optical amplifier according to claim 16, wherein the first optical signal is the input optical signal, the optical amplifier further comprises an input port, and the second multiplexer/demultiplexer is connected to the input port; and
the input port is configured to receive the input optical signal of the optical amplifier, and output the input optical signal to the second multiplexer/demultiplexer.

18. The optical amplifier according to claim 16, wherein the first optical signal is the optical signal obtained by amplifying the input optical signal of the optical amplifier, the optical amplifier further comprises a second gain medium, and the second gain medium is connected to the second multiplexer/demultiplexer; and
the second gain medium is configured to: receive and amplify the input optical signal of the optical amplifier, to obtain the first optical signal, and output the first optical signal to the second multiplexer/demultiplexer.

19. The optical amplifier according to any one of claims 16 to 18, wherein the optical amplifier further comprises a narrow band-pass filter;
the narrow band-pass filter is comprised in a target loop, the target loop comprises the second multiplexer/demultiplexer, the first gain medium, and the first multiplexer/demultiplexer, and the target loop is configured to transmit the first gain clamping light; and
the narrow band-pass filter is configured to control a bandwidth of the first gain clamping light, to generate laser light on the target loop based on the first gain clamping light.

20. An optical communication device, comprising the optical amplifier according to any one of claims 1 to 15 or 16 to 19.

21. An optical communication system, comprising the optical amplifier according to any one of claims 1 to 15 or 16 to 19.
